(19) Europäisches Patentamt / European Patent Office / Office européen des brevets

(11) **EP 4 745 967 A2**

## (12) EUROPEAN PATENT APPLICATION

(43) Date of publication:
**20.05.2026 Bulletin 2026/21**

(21) Application number: **25214675.8**

(22) Date of filing: **10.11.2025**

(51) International Patent Classification (IPC):
*G11C 5/04* [(2006.01)]

(52) Cooperative Patent Classification (CPC):
**G11C 5/04**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **15.11.2024 JP 2024199526**

(71) Applicant: **Nitto Denko Corporation**
**Ibaraki-shi, Osaka 567-6680 (JP)**

(72) Inventors:
• **FUKAMICHI, Yuichi**
**Ibaraki-shi, 5678680 (JP)**
• **MAKITA, Katsuhiko**
**Ibaraki-shi, 5678680 (JP)**
• **TAKAHASHI, Seina**
**Ibaraki-shi, 5678680 (JP)**

(74) Representative: **Stolmár & Partner**
**Patentanwälte PartG mbB**
**Blumenstraße 17**
**80331 München (DE)**

(54) **SHEET FOR SINTER BONDING, COMPOSITION, VARNISH, AND DICING TAPE ATTACHED WITH SHEET FOR SINTER BONDING**

(57) A sheet for sinter bonding including: a sinterable particle containing an electroconductive metal; and a binder, wherein a distance Db between a Hansen solubility parameter of the sinterable particle and a Hansen solubility parameter of the binder is less than 15.0.

FIG. 1

EP 4 745 967 A2

**Description**

BACKGROUND

Technical Field

The present invention relates to a sheet for sinter bonding, a composition, a varnish, and a dicing tape attached with a sheet for sinter bonding.

Related Art

As a semiconductor material, there is an increasing demand for a power semiconductor to which silicon carbide (SiC) or gallium nitride (GaN) is applied and with which high current and high voltage can be handled. A power semiconductor is required to be stably usable even during operation when high current causes heat generation and high temperature.

As a method for die-bonding these semiconductor chips such as power semiconductors to a support substrate, a method of using a sinterable particle containing an electro-conductive metal such as silver or copper to ensure electrical connection and mechanical bonding has been proposed in addition to conventionally known solder, paste, and the like (JP 2024-010136 A). In the bonding using a sinterable particle, a composition containing a sinterable particle, a solvent, and the like is applied onto a support substrate, a semiconductor chip is placed thereon, and they are heated to volatilize the solvent and the like and proceed the sintering of the sinterable particle, thereby forming a sintered layer between the support substrate and the semiconductor chip.

In the bonding using a sinterable particle described above, when a composition containing a sinterable particle is applied onto a support substrate, there is a tendency that it is difficult to form a bonding layer having a uniform thickness and uniformly proceed the sintering of the sinterable particle. From such a viewpoint, sheet-like bonding materials capable of maintaining a predetermined shape at normal temperature have been proposed, such as the sheet-like bonding material containing a sinterable particle described in WO 2008/065728 A1.

SUMMARY

Sheets for sinter bonding, having a sheet-like shape and containing a sinterable particle, may have particle unevenness before the sheet is sintered, and may have cracking or chipping when the sheet is processed, in some cases.

Therefore, an object of the present invention is to provide a sheet for sinter bonding that contains a sinterable particle and a binder, and hardly has particle unevenness in the sheet, or cracking or chipping when the sheet is processed.

As a result of intensive studies to solve the above problems, the present inventors have found that the above problems can be solved, and have completed the present invention having the following gist.

That is, the present invention includes the following.

[1] A sheet for sinter bonding including: a sinterable particle containing an electro-conductive metal; and a binder, wherein a distance Db between a Hansen solubility parameter of the sinterable particle and a Hansen solubility parameter of the binder is less than 15.0.

[2] The sheet for sinter bonding according to [1], containing no binder other than a thermally decomposable polymer binder the distance Db of which is less than 15.0.

[3] The sheet for sinter bonding according to [1] or [2], wherein the distance Db is 10.0 or less.

[4] The sheet for sinter bonding according to any one of [1] to [3], wherein the binder contains at least one selected from the group consisting of polypropylene carbonate and polyethylene carbonate.

[5] A dicing tape attached with a sheet for sinter bonding, including:

a dicing tape having a base material and an adhesive; and
the sheet for sinter bonding according to any one of [1] to [4] attached to the adhesive of the dicing tape.

[6] A composition for sinter bonding including: a sinterable particle containing an electro-conductive metal; and a binder,
wherein a distance Db between a Hansen solubility parameter of the sinterable particle and a Hansen solubility parameter of the binder is less than 15.0.

[7] A varnish for sinter bonding including: a sinterable particle containing an electro-conductive metal; a binder; and a dispersing solvent,

wherein a distance Db between a Hansen solubility parameter of the sinterable particle and a Hansen solubility parameter of the binder is less than 15.0, and

a distance Ds between a Hansen solubility parameter of the sinterable particle and a Hansen solubility parameter of the dispersing solvent is less than 15.0.

According to the present invention, it is possible to provide a sheet for sinter bonding that hardly has particle unevenness in the sheet, or cracking or chipping when the sheet is processed.

BRIEF DESCRIPTION OF DRAWINGS

FIG. 1 is a schematic cross-sectional view showing an example of a dicing tape attached with a sheet for sinter bonding in an embodiment;

FIG. 2A is a schematic cross-sectional view showing a part of the steps of a method for producing a semiconductor using a dicing tape attached with a sheet for sinter bonding in an embodiment;

FIG. 2B is a schematic cross-sectional view showing another part of the steps of a method for producing a semiconductor using a dicing tape attached with a sheet for sinter bonding in an embodiment;

FIG. 2C is a schematic cross-sectional view showing another part of the steps of a method for producing a semiconductor using a dicing tape attached with a sheet for sinter bonding in an embodiment; and

FIG. 2D is a schematic cross-sectional view showing another part of the steps of a method for producing a semiconductor using a dicing tape attached with a sheet for sinter bonding in an embodiment.

DETAILED DESCRIPTION

(Sheet for sinter bonding)

The sheet for sinter bonding can be used for sinter-bonding between objects to be bonded, for example, between a semiconductor chip and a support substrate, and contains: a sinterable particle containing an electro-conductive metal; and a binder. The sheet for sinter bonding, having a shape maintaining a predetermined thickness, easily uniformizes the thickness of the sintered layer formed between the objects to be bonded, and easily realizes a highly reliable bonding due to uniformly proceeded sintering.

The sheet for sinter bonding of the present invention contains a sinterable particle and a binder, wherein the distance Db between the Hansen solubility parameter of the sinterable particle and the Hansen solubility parameter of the binder is less than 15.0. Such a sheet for sinter bonding containing a sinterable particle and a binder easily disperses the sinterable particle uniformly in the sheet. Such a sheet is obtained presumably because the compatibility between the sinterable particle and the binder is improved to a predetermined level or higher due to the distance Db being within the above range. Therefore, the sheet for sinter bonding hardly has particle unevenness, and hardly has cracking or chipping when the sheet is processed. In addition, when the sheet for sinter bonding is used for sinter-bonding, the sheet is less likely to leak from the objects to be bonded such as semiconductor chips even under heating or pressing for bonding, and a sintered layer that maintains the original sheet shape is easily obtained after the bonding.

The size and plan-view shape of the sheet for sinter bonding are not particularly limited. The plan-view shape may be any shape and size such as a rectangular shape and a circular shape, according to each step and apparatus of the semiconductor manufacturing apparatus.

<Hansen solubility parameter>

The distance Db between the Hansen solubility parameter of the sinterable particle ($\delta Dx$, $\delta Px$, $\delta Hx$) and the Hansen solubility parameter of the binder ($\delta Dy$, $\delta Py$, $\delta Hy$) is less than 15.0. From the viewpoint of easily forming a sheet in which the sinterable particle is more uniformly dispersed, the distance Db is preferably 13.0 or less, and more preferably 10.0 or less. The lower limit of the distance Db between the Hansen solubility parameter of the sinterable particle and the Hansen solubility parameter of the binder is not particularly limited. From the viewpoint of promoting the thermal decomposition of the binder during the sinter-bonding, the distance Db may be 3.0 or more, or may be 5.0 or more.

The Hansen solubility parameter (HSP) is obtained by dividing the Hildebrand solubility parameter $\delta$ into a dispersion term D, a polarity term P, and a hydrogen bond term H. The distance Db between the Hansen solubility parameter of the sinterable particle ($\delta Dx$, $\delta Px$, $\delta Hx$) and the Hansen solubility parameter of the binder ($\delta Dy$, $\delta Py$, $\delta Hy$) is represented by the following formula (1). When expressed in the three-dimensional coordinate, the target substances tend to be more easily dissolved to each other (the compatibility is higher) as the distance D of the Hansen solubility parameter is shorter.

[Mathematical formula 1]

$$Db = \sqrt{4(\delta Dx - \delta Dy)^2 + (\delta Px - \delta Py)^2 + (\delta Hx - \delta Hy)^2} \qquad (1)$$

In the formula (1), $\delta Dx$, $\delta Px$, and $\delta Hx$ each represent the dispersion term, the polarity term, and the hydrogen bond term of the Hansen solubility parameter of the sinterable particle; and $\delta Dy$, $\delta Py$, and $\delta Hy$ each represent the dispersion term, the polarity term, and the hydrogen bond term of the Hansen solubility parameter of the binder.

Among the binders, for a substance whose chemical structure has been known such as isobornyl cyclohexanol (MTPH), the Hansen solubility parameter thereof can be referred to based on information sources known in databases and the like. Therefore, for a substance whose chemical structure has been known, for example, the Hansen solubility parameter thereof can be calculated by a method of inputting the Smiles form of the chemical structural formula into an HSP calculation software. In addition, also for a substance whose chemical structure has been known such as solvents other than the above, the Hansen solubility parameter thereof can be calculated likewise using the Smiles form.

For a substance whose parameter is not registered in databases, such as a sinterable particle containing a surface-treated electro-conductive metal as described later among the sinterable particles, and the binder, the Hansen solubility parameter thereof can be calculated, for example, by the Hansen sphere method (Hansen dissolution sphere method), as described below. The Hansen sphere method is a method in which the substance to be measured is dissolved (dispersed) in solvents whose Hansen solubility parameter has been known, the measurement results thereof are plotted in the three-dimensional coordinate, and the parameter thereof is calculated from the range of a sphere including the coordinates of solvents dissolving the sample and not including the coordinates of solvents not dissolving the sample, as the Hansen sphere. The Hansen solubility parameter from the Hansen sphere method may be measured, for example, under an environment of 25°C.

<Sinterable particle>

The sinterable particle contains an electro-conductive metal. The sinterable particle is a particle that can be sintered when heated to a sinter-bonding temperature (for example, about 300°C). Examples thereof include gold Au, silver Ag, copper Cu, palladium Pd, tin Sn, nickel Ni, alloys of two or more of these metals, and metal oxides thereof. The sinterable particle preferably contains one or more of a silver particle, a copper particle, a silver oxide particle, and a copper oxide particle. This is because a strong sintered layer is easily formed through sinter-bonding. In addition, from the viewpoint of easily forming a sintered layer having high electric conductivity and high thermal conductivity through sinter-bonding, the sinterable particle preferably contains a silver particle or a copper particle. From the viewpoint of easily suppressing ion migration and insulation failure due to ion migration, and easily improving the reliability of a semiconductor substrate, the sinterable particle is particularly preferably a copper particle.

As the sinterable particle, it is also preferable to use a particle obtained by surface-treating the surface of the electro-conductive metal with an organic film, a polymer, or the like. When the sinterable particle is surface-treated, uniform dispersibility of the sinterable particle in the sheet for sinter bonding is easily maintained, and degeneration of the electro-conductive metal due to surface oxidation or the like is easily suppressed. The surface treatment agent for the electro-conductive metal is not particularly limited, and an appropriate surface treatment agent may be selected according to the type of metal. Examples of the surface treatment agent for the electro-conductive metal include polymers having a carboxy group, a sulfonic acid group, a phosphoric acid group, an amino group, an imino group, an ammonium group, or the like, various nonionic surfactants, polymer protective colloids, and the like.

The purpose of the surface treatment of the electro-conductive metal is not particularly limited, and it is preferable to apply a surface treatment agent suitable for the purpose according to the type of the electro-conductive metal. For example, when the electro-conductive metal is silver, the surface treatment agent may be applied with a wide variety of materials as long as the material is likely to be detached (disappeared) in the sintering step. On the other hand, when the electro-conductive metal is copper, there is a tendency that copper is easily oxidized, and copper oxide is hardly removed when oxidized. For this reason, there is a tendency that it is important for the copper surface treatment agent to have a covering property in order to reliably suppress the oxidation of copper.

When the surface of the electro-conductive metal in the sinterable particle is surface-treated, the Hansen solubility parameter ($\delta Dx$, $\delta Px$, $\delta Hx$) of the sinterable particle varies depending on the type of the surface treatment agent and the like. The Hansen solubility parameter of the sinterable particle can be calculated, for example, by the Hansen sphere method as described above, and measured such that the sinterable particle is dissolved (dispersed) in a solvent whose Hansen solubility parameter has been known. This is because the surface treatment agent has an influence on the dispersion of the surface-treated electro-conductive metal in a solvent for the Hansen sphere method.

From the above, in the sheet for sinter bonding, the distance Db between the Hansen solubility parameter of the sinterable particle and the Hansen solubility parameter of the binder also varies depending on the type of the surface treatment agent of the electro-conductive metal in the sinterable particle and the like.

The average particle size D50 of the sinterable particle is preferably 10000 nm or less, more preferably 3000 nm or less, and particularly preferably 1000 nm or less. This is because when the average particle size is the above values or less, the smoothness of the surface of the sheet for sinter bonding is easily ensured. The average particle size D50 of the sinterable particle is preferably 1 nm or more, more preferably 10 nm or more, and particularly preferably 50 nm or more. This is because when the average particle size is the above values or more, the sheet for sinter bonding or the composition for forming the sheet easily maintains the state where the sinterable particle is uniformly dispersed. In the present specification, the average particle size D50 is a volume-based average particle size.

The average particle size of the sinterable particle can be measured by observation with a scanning electron microscope (SEM). Specifically, the sheet containing the sinterable particle is cooled and cut, the exposed cross section is imaged with a field emission scanning electron microscope SU8020 (manufactured by Hitachi High-Tech Corporation), and the average particle size can be calculated based on the obtained image data. Examples of the imaging conditions include an acceleration voltage of 5 kV and a magnification of 50000 times. The image data can be binarized using image analysis software ImageJ, and used for calculation of the average particle size.

The content ratio of the sinterable particle in the sheet for sinter bonding is preferably 85 to 98 mass%, more preferably 87 to 98 mass%, and particularly preferably 88 to 98 mass%. Within the above range, the bonding part after sintering easily maintains high thermal conductivity, and the sinterable particle hardly leaks from between the adherends (for example, a semiconductor chip, a substrate, or the like) during sinter-bonding (the sinterable particle easily maintains a predetermined shape during sinter-bonding, and hardly causes deformation or protrusion from between the adherends). In this regard, as for the content ratio of the sinterable particle, as the number of sinterable particles increases, the viscosity of the sheet for sinter bonding is easily kept high even at the time of heating, the sinterable particle hardly leaks from between the adherends, and the sintered body easily has a dense structure and maintains high bonding strength and reliability even after sinter-bonding. On the other hand, when the number of sinterable particles is too small, the viscosity is easily lowered due to other organic components and the like at the time of heating or pressurizing during sinter-bonding. Therefore, the sinterable particle easily leaks from between the adherends, and the sintered body after sinter-bonding easily has a large number of voids and may become fragile.

<Binder>

The binder contained in the sheet for sinter bonding can be applied such that the distance Db between the Hansen solubility parameter of the sinterable particle and the Hansen solubility parameter of the binder is less than 15.0. The binder only needs to include a binder having a distance Db of less than 15.0, and may include a binder having a distance Db of 15.0 or more. It is preferable to contain no binder other than a thermally decomposable polymer binder the distance Db of which is less than 15.0 (contain only a thermally decomposable polymer binder the distance Db of which is less than 15.0).

Here, the thermally decomposable polymer binder is a binder made of a polymer material (having a molecular weight of about 1000 or more) at least a part of which is thermally decomposed at a general sintering temperature (for example, when heated at about 300°C or more). The thermally decomposable polymer binder is preferably made of a polymer material 50% or more of which is thermally decomposed at 300°C. The thermally decomposable polymer binder is preferably not thermally decomposed before heated at the sintering temperature, in order to maintain the sheet shape of the sheet for sinter bonding. Therefore, the thermally decomposable polymer binder is preferably a solid material at normal temperature (23°C). Examples of the thermally decomposable polymer binder include one or more of a polycarbonate resin and an acrylic resin. When these materials are applied, it is easy to reduce organic residues derived from the binder remaining in the sintered layer.

When the objects to be bonded are temporarily fixed before sintering, the thermally decomposable polymer binder easily secures adhesiveness to the objects to be bonded, using the viscoelasticity of the binder, at a temporary fixing temperature (for example, about 70°C). When the sinter-bonding sheet applied with the thermally decomposable polymer binder is used, the positional deviation of the objects to be bonded is easily prevented when the objects to be bonded are pressure-bonded to each other, or after the pressure-bonding thereof.

When the binder of the sheet for sinter bonding includes one or more of a polycarbonate resin and an acrylic resin, the binder easily decomposes and disappears by sintering. Therefore, when these binders are used, organic residues are easily reduced in the sintered layer. When the amount of organic residues remaining after sintering is small, the objects to be bonded are firmly bonded, and high bonding reliability is easily obtained.

Examples of the polycarbonate resin include aliphatic polycarbonates and aromatic polycarbonates. Here, the aliphatic polycarbonate does not contain an aromatic compound in the main chain and is composed of an aliphatic chain. The aromatic polycarbonate contains an aromatic compound in the main chain. The main chain of the polycarbonate herein refers to a chain having a carbonate group.

Examples of the aliphatic polycarbonate include polyethylene carbonate and polypropylene carbonate. Examples of the aromatic polycarbonate include a polycarbonate having a bisphenol A structure in the main chain.

Examples of the acrylic resin include polymers of acrylic acid esters and methacrylic acid esters. These polymers may have a linear or branched alkyl group preferably having 4 to 18 carbon atoms. In the present specification, "(meth)acrylic" represents one or both of "acrylic" and "methacrylic".

Examples of the alkyl group of the (meth)acrylic acid ester include a methyl group, an ethyl group, a propyl group, an isopropyl group, a n-butyl group, a t-butyl group, an isobutyl group, an amyl group, an isoamyl group, a hexyl group, a heptyl group, a cyclohexyl group, a 2-ethylhexyl group, an octyl group, an isooctyl group, a nonyl group, an isononyl group, a decyl group, an isodecyl group, an undecyl group, a lauryl group, a tridecyl group, a tetradecyl group, a stearyl group, and an octadecyl group.

The acrylic resin may be a polymer containing a monomer unit derived from another monomer other than a (meth)acrylic acid ester. Examples of such another monomer include a carboxy group-containing monomer, an acid anhydride monomer, a hydroxy group-containing monomer, a sulfonic acid group-containing monomer, and a phosphoric acid group-containing monomer. Examples of the carboxy group-containing monomer include acrylic acid, methacrylic acid, carboxyethyl acrylate, carboxypentyl acrylate, itaconic acid, maleic acid, fumaric acid, and crotonic acid. Examples of the acid anhydride monomer include maleic anhydride and itaconic anhydride. Examples of the hydroxy group-containing monomer include 2-hydroxyethyl(meth)acrylate, 2-hydroxypropyl(meth)acrylate, 4-hydroxybutyl(meth)acrylate, 6-hydroxyhexyl(meth)acrylate, 8-hydroxyoctyl(meth)acrylate, 10-hydroxydecyl(meth)acrylate, 12-hydroxylauryl(meth)acrylate, and 4-(hydroxymethyl)cyclohexylmethyl(meth)acrylate. Examples of the sulfonic acid group-containing monomer include styrene sulfonic acid, allyl sulfonic acid, 2-(meth)acrylamide-2-methylpropane sulfonic acid, (meth)acrylamide propane sulfonic acid, sulfopropyl(meth)acrylate, and (meth)acryloyloxy naphthalene sulfonic acid. Examples of the phosphoric acid group-containing monomer include 2-hydroxyethyl acryloyl phosphate.

The binder preferably contains a polyalkylene carbonate, and the polyalkylene carbonate is a polymer having repeating units of $-OC(=O)-O-C_nH_{2n}-$ (n is an integer of 2 to 12). The binder preferably contains at least one selected from the group consisting of polypropylene carbonate (PPC) and polyethylene carbonate (PEC). When the binder contains them, the distance Db between the Hansen solubility parameters tends to be 15.0 or less. Particularly when a sinterable particle containing a copper particle as an electro-conductive metal is used, the distance Db tends to be 15.0 or less. PPC and PEC are suitable as a binder because of their relatively low thermal decomposition temperature (about 300°C).

As the binder, it is preferable that an appropriate type thereof is selected depending on the constituent metal of the sinterable particle, the surface treatment of the surface of the sinterable particle, and the like. This is because the sheet for sinter bonding the distance Db of which is within the above described range is easily obtained.

For example, the binder to be applied may be determined with reference to values such as $\delta Dx$ and $\delta Px$ in the Hansen solubility parameter (HSP) of the sinterable particle. For example, when $\delta Dx$ of the sinterable particle is less than 20.0, application of the above-described PPC as the binder may be examined, and when $\delta Dx$ is 20.0 or more, application of PEC as the binder may be examined. Further, when $\delta Px$ is less than 10.0, application of PEC as the binder may be considered, and when $\delta Px$ is 10.0 or more, application of the above-described PPC as the binder may be considered.

The weight average molecular weight of the binder is preferably 10000 or more. Within the above-described range, the sheet for sinter bonding easily secures cohesive force (how easily a tough sheet is obtained because of the sinterable particle contained therein) and adhesive force, using the viscoelasticity of the binder. The weight average molecular weight of the binder can be measured by gel permeation chromatography (GPC) and calculated in terms of polystyrene.

The content ratio of the binder in the sheet for sinter bonding is preferably 0.5 to 10.0 mass%, more preferably 0.8 to 8.0 mass%, and particularly preferably 1.0 to 6.0 mass%. When the content ratio of the binder is within the above-described range, the sheet for sinter bonding easily maintains an appropriate shape.

The binder may further contain a low molecular binder (having a molecular weight of less than 1000). The low molecular binder preferably has a distance Db of less than 15.0. The low molecular binder is preferably a low boiling point binder. The low boiling point binder is a binder component that starts thermal decomposition (weight reduction) at a temperature lower than the thermal decomposition start temperature of a polymer binder such as a thermally decomposable polymer binder (for example, about 200°C).

The low molecular binder is preferably a liquid or semi-liquid having a viscosity of $1 \times 10^5$ Pa·s or less at 23°C measured using a dynamic viscoelasticity measuring device (trade name: "HAAKE MARS III", manufactured by Thermo Fisher Scientfic). The above measurement can be performed using a parallel plate of 20 mmφ with an inter-plate gap of 100 μm and a shear rate of 1 s$^{-1}$ in rotational shearing.

Examples of the low molecular binder include terpene alcohols, alcohols other than terpene alcohols, alkylene glycol alkyl ethers, and ethers other than alkylene glycol alkyl ethers. Examples of the terpene alcohols include isobornyl cyclohexanol, citronellol, geraniol, nerol, carveol, and α-terpineol. Examples of the alcohols other than terpene alcohols include pentanol, hexanol, heptanol, octanol, 1-decanol, ethylene glycol, diethylene glycol, propylene glycol, butylene glycol, and 2,4-diethyl-1,5-pentanediol. Examples of the alkylene glycol alkyl ethers include ethylene glycol butyl ether, diethylene glycol methyl ether, diethylene glycol ethyl ether, diethylene glycol butyl ether, diethylene glycol isobutyl ether, diethylene glycol hexyl ether, triethylene glycol methyl ether, diethylene glycol dimethyl ether, diethylene glycol diethyl ether, diethylene glycol dibutyl ether, diethylene glycol butyl methyl ether, diethylene glycol isopropyl methyl ether, triethylene glycol dimethyl ether, triethylene glycol butyl methyl ether, propylene glycol propyl ether, dipropylene glycol methyl ether, dipropylene glycol ethyl ether, dipropylene glycol propyl ether, dipropylene glycol butyl ether, dipropylene glycol dimethyl ether, tripropylene glycol methyl ether, and tripropylene glycol dimethyl ether. Examples of the ethers other than alkylene glycol alkyl ethers include ethylene glycol ethyl ether acetate, ethylene glycol butyl ether acetate, diethylene glycol ethyl ether acetate, diethylene glycol butyl ether acetate, dipropylene glycol methyl ether acetate, and ethylene glycol phenyl ether. The low molecular binder may be one kind or two or more kinds. The low molecular binder is preferably terpene alcohols and more preferably isobornyl cyclohexanol from the viewpoint of stability at room temperature.

The content ratio of the low molecular binder in the sheet for sinter bonding is preferably 1.0 to 50.0 mass%. Within the above range, it is easy to secure tackiness on the surface of the sheet for sinter bonding, which is effective for the step of bonding with the objects to be bonded.

The binder described above preferably contains only binders having a distance Db of less than 15.0. Between organic components contained in the sheet for sinter bonding, the distance between the Hansen solubility parameters of any two components is preferably less than 15.0. When the sheet for sinter bonding is as described above, the sinterable particle hardly protrudes from between the adherends even under heating or pressurizing at the time of sintering.

The sheet for sinter bonding may contain other components other than the above components. The sheet for sinter bonding may contain, for example, a plasticizer.

<Physical properties>

The thickness of the sheet for sinter bonding is preferably 5 μm or more, and more preferably 10 μm or more. The thickness of the sheet for sinter bonding is preferably 300 μm or less, and more preferably 150 μm or less. When the thickness is within the above range, handleability during semiconductor manufacturing is easily maintained, and the sinterable particle hardly protrudes from between adherends at the time of sintering.

The porosity of the sheet for sinter bonding is preferably 10% or less, more preferably 8% or less, and particularly preferably 6% or less. The porosity may be 0%, and is preferably 1% or more from the viewpoint of easily maintaining appropriate flexibility of the sheet. When the porosity is within the above range, the sinterable particle after sintering exists at a high density, thereby easily realizing a highly reliable bonding. The porosity of the sheet for sinter bonding can be measured in the sintered layer after the sheet for sinter bonding is heated and sintered at 300°C for 2.5 minutes under a pressure condition of 10 MPa.

Each component contained in the sheet for sinter bonding can be measured by the following analysis method.

The sheet for sinter bonding is subjected to solvent extraction with a solvent such as methanol, acetone, ethyl acetate, methylene chloride, chloroform, or hexane, so that the organic components derived from the binder are dissolved and removed into the solvent. After solvent extraction, the sinterable particle remaining as solid is isolated.

For the binder, the solvent after solvent extraction can be qualitatively analyzed to measure the components by infrared absorption spectroscopy (IR), gas chromatography mass spectrometry (GC/MAS), liquid chromatography mass spectrometry (LC/MS), or the like.

For the sinterable particle, the components of the surface treatment agent can be measured by: a method of specifying organic decomposition products derived from the surface treatment agent through pyrolysis gas chromatography (GC/MAS); or by LC/MS or GC/MAS after the bond between the electro-conductive metal and components such as carboxylic acids in the surface treatment agent is cut through high temperature methanol decomposition.

(Composition for sinter bonding)

The sheet for sinter bonding can be produced using a composition for sinter bonding or a varnish for sinter bonding.

The composition for sinter bonding contains: a sinterable particle containing an electro-conductive metal; and a binder, wherein the distance Db between the Hansen solubility parameter of the sinterable particle and the Hansen solubility parameter of the binder is less than 15.0.

As the sinterable particle and the binder contained in the composition for sinter bonding, those as in the sheet for sinter bonding can be applied.

The content ratio of the sinterable particle in the composition for sinter bonding is preferably 85 to 98 mass%, more preferably 87 to 98 mass%, and particularly preferably 88 to 98 mass%. When the content ratio of the sinterable particle is within the above range, the bonding part after sintering easily maintains high thermal conductivity, and the sinterable particle hardly leaks from between the adherends during sinter-bonding. In addition, when the content ratio of the sinterable particle is increased, the sintered body easily has a dense structure and maintains high bonding strength and reliability even after sinter-bonding.

(Varnish for sinter bonding)

The varnish for sinter bonding contains: a sinterable particle containing an electro-conductive metal; a binder; and a dispersing solvent, wherein the distance Db between the Hansen solubility parameter of the sinterable particle ($\delta$Dx, $\delta$Px, $\delta$Hx) and the Hansen solubility parameter of the binder ($\delta$Dy, $\delta$Py, $\delta$Hy) is less than 15.0, and the distance Ds between the Hansen solubility parameter of the sinterable particle ($\delta$Dx, $\delta$Px, $\delta$Hx) and the Hansen solubility parameter of the dispersing solvent ($\delta$Dz, $\delta$Pz, $\delta$Hz) is less than 15.0.

As the sinterable particle and the binder contained in the varnish for sinter bonding, those as in the sheet for sinter bonding can be applied. The formula indicating the distance Db is similar to the above formula (1).

The distance Ds between the Hansen solubility parameter of the sinterable particle ($\delta$Dx, $\delta$Px, $\delta$Hx) and the Hansen solubility parameter of the dispersing solvent ($\delta$Dz, $\delta$Pz, $\delta$Hz) is shown by the following formula (2).

[Mathematical formula 2]

$$\mathrm{Ds} = \sqrt{4(\delta \mathrm{Dx} - \delta \mathrm{Dz})^2 + (\delta \mathrm{Px} - \delta \mathrm{Pz})^2 + (\delta \mathrm{Hx} - \delta \mathrm{Hz})^2} \qquad (2)$$

In the formula (1), $\delta$Dx, $\delta$Px, and $\delta$Hx each represent the dispersion term, the polarity term, and the hydrogen bond term of the Hansen solubility parameter of the sinterable particle; and $\delta$Dz, $\delta$Pz, and $\delta$Hz each represent the dispersion term, the polarity term, and the hydrogen bond term of the Hansen solubility parameter of the dispersing solvent.

Between organic components contained in the varnish for sinter bonding, the distance between the Hansen solubility parameters of any two components is preferably less than 15.0. When the varnish for sinter bonding is as described above, it is easy to uniformly disperse the raw materials in the varnish, and it is easy to form a sheet for sinter bonding whose sinterable particle hardly protrudes from between the adherends even under heating or pressurizing at the time of sintering. As a result, obtained is a sheet for sinter bonding that hardly has particle unevenness, or cracking or chipping during processing.

<Dispersing solvent>

As the dispersing solvent contained in the varnish for sinter bonding, an organic solvent or an alcohol solvent can be used.

Examples of the organic solvent include dimethylformamide, dimethylacetamide, N-methylpyrrolidone, acetone, methyl ethyl ketone, cyclohexanone, toluene, and xylene. Examples of the alcohol solvent include ethylene glycol, diethylene glycol, 1,2-propanediol, 1,3-propanediol, 1,2-butanediol, 1,3-butanediol, 1,4-butanediol, 2-butene-1,4-diol, 1,2,6-hexanetriol, glycerin, octanediol, 2-methyl-2,4-pentanediol, and terpineol.

(Dicing tape)

The sheet for sinter bonding is preferably used in a semiconductor manufacturing process together with a dicing tape.

The dicing tape includes a base material and an adhesive. The dicing tape attached with a sheet for sinter bonding in which the adhesive of the dicing tape is attached with the sheet for sinter bonding of the present invention is suitably used in a semiconductor manufacturing process.

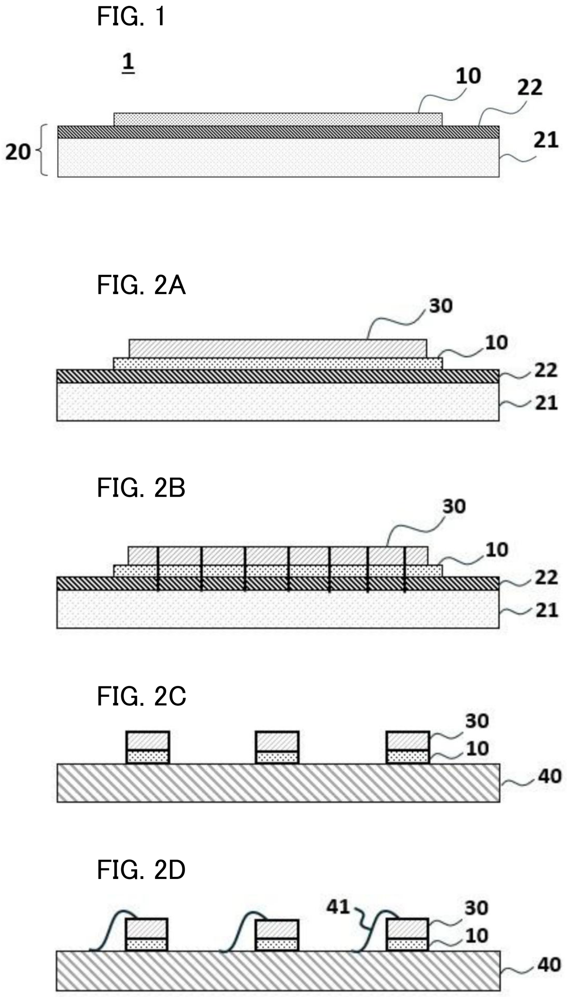

FIG. 1 is a schematic cross-sectional view showing an example of a dicing tape attached with a sheet for sinter bonding. Hereinafter, description will be given with reference to FIG. 1.

A dicing tape 1 attached with a sheet for sinter bonding includes a dicing tape 20 having a base material 21 and an adhesive 22. The dicing tape 1 attached with a sheet for sinter bonding includes a sheet for sinter bonding 10 attached to the adhesive 22.

The shape of the sheet for sinter bonding 10 may be the same as, or different from, the shape of the dicing tape 20. The sheet for sinter bonding 10 may have any shape in plan view, and may have, for example, a rectangular shape or a circular shape. Further, one dicing tape 20 may have a plurality of sheets for sinter bonding 10.

The dicing tape 1 attached with a sheet for sinter bonding may have any layer other than the above layers.

<Adhesive>

The adhesive 22 is provided so that the base material 21 and the sheet for sinter bonding 10 can be attached to each other. The adhesive 22 is not necessarily provided on the entire surface of the base material 21, and may be provided only at a position corresponding to the sheet for sinter bonding 10. Further, the adhesive 22 is not necessarily formed in a layer shape, and for example, may be provided in a discontinuous shape such as a dot shape or a stripe shape in plan view of the base material 21.

Examples of the adhesive include: an acrylic adhesive based on an acrylic polymer; and a rubber adhesive. The adhesive may be an adhesive whose adhesive force can be reduced by an external action such as heating or radiation irradiation (adhesive force reduction type adhesive). The adhesive may be an adhesive whose adhesive force is not reduced at all (or hardly reduced) by an external action (non-adhesive force reduction type adhesive). Examples of the adhesive force reduction type adhesive include a radiation curable adhesive (adhesive having radiation curability) and a heat foaming adhesive. Examples of the non-adhesive force reduction type adhesive include a pressure-sensitive adhesive.

When the adhesive contains an acrylic adhesive, the acrylic polymer, serving as the base of the acrylic adhesive, preferably contains a monomer unit derived from an acrylic acid alkyl ester and/or a methacrylic acid alkyl ester. In addition, these monomer units are preferably contained as the monomer unit that is contained in the largest mass ratio in the adhesive.

Examples of the (meth)acrylic acid alkyl ester include (meth)acrylic acid alkyl esters having a linear or branched alkyl group and (meth)acrylic acid cycloalkyl esters. Examples of the (meth)acrylic acid alkyl ester include methyl ester, ethyl ester, propyl ester, isopropyl ester, butyl ester, isobutyl ester, s-butyl ester, t-butyl ester, pentyl ester, isopentyl ester, hexyl ester, heptyl ester, octyl ester, 2-ethylhexyl ester, isooctyl ester, nonyl ester, decyl ester, isodecyl ester, undecyl ester, dodecyl ester, tridecyl ester, tetradecyl ester, hexadecyl ester, octadecyl ester, and eicosyl ester of (meth)acrylic acid. Examples of the (meth)acrylic acid cycloalkyl ester include cyclopentyl ester and cyclohexyl ester of (meth)acrylic acid. For the (meth)acrylic acid alkyl ester, only one kind thereof may be used, or two or more kinds thereof may be used.

The proportion of the (meth)acrylic acid alkyl ester in all the monomer components is preferably 50 mass% or more. This is because when the proportion is within the above range, basic characteristics such as adhesive strength of the adhesive are easily exhibited appropriately.

The acrylic polymer may further contain a monomer unit derived from another monomer copolymerizable with the (meth)acrylic acid alkyl ester. When these monomer units are contained, cohesive force, heat resistance, and the like are easily modified. Examples of such monomers include a carboxy group-containing monomer, an acid anhydride monomer, a hydroxy group-containing monomer, a sulfonic acid group-containing monomer, a phosphoric acid group-containing monomer, acrylamide, and acrylonitrile. Examples of the carboxy group-containing monomer include acrylic acid, methacrylic acid, carboxyethyl (meth)acrylate, carboxypentyl (meth)acrylate, itaconic acid, maleic acid, fumaric acid, and crotonic acid. Examples of the acid anhydride monomer include maleic anhydride and itaconic anhydride. Examples of the hydroxy group-containing monomer include 2-hydroxyethyl(meth)acrylate, 2-hydroxypropyl(meth)acrylate, 4-hydroxybutyl(meth)acrylate, 6-hydroxyhexyl(meth)acrylate, 8-hydroxyoctyl(meth)acrylate, 10-hydroxydecyl(meth)acrylate, 12-hydroxylauryl(meth)acrylate, and 4-(hydroxymethyl)cyclohexylmethyl(meth)acrylate. Examples of the sulfonic acid group-containing monomer include styrene sulfonic acid, allyl sulfonic acid, 2-(meth)acrylamide-2-methylpropane sulfonic acid, (meth)acrylamide propane sulfonic acid, sulfopropyl(meth)acrylate, and (meth)acryloyloxy naphthalene sulfonic acid. Examples of the phosphoric acid group-containing monomer include 2-hydroxyethyl acryloyl phosphate. Such another monomer may be one kind of monomer or two or more kinds of monomers.

The proportion of the monomers other than the (meth)acrylic acid alkyl ester in all the monomer components that form the acrylic polymer is preferably 50 mass% or less. This is because when the proportion is within the above range, basic characteristics such as adhesive strength of the adhesive are easily exhibited appropriately.

The acrylic polymer may further contain a monomer unit derived from a polyfunctional monomer copolymerizable with the (meth)acrylic acid alkyl ester to form a crosslinked structure in the polymer skeleton. Examples of the polyfunctional monomer include hexanediol di(meth)acrylate, (poly)ethylene glycol di(meth)acrylate, (poly)propyleneglycol di(meth)acrylate, neopentylglycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy (meth)acrylate, glycidyl (meth)acrylate, polyester (meth)acrylate, and urethane (meth)acrylate. The polyfunctional monomer may be one kind of monomer or two or more kinds of monomers.

The proportion of the polyfunctional monomer in all the monomer components is preferably 40 mass% or less. This is because when the proportion is within the above range, basic characteristics such as adhesive strength of the adhesive are easily exhibited appropriately.

The adhesive may contain, for example, an external crosslinking agent in order to increase the number average molecular weight of the base polymer such as an acrylic polymer. Examples of the external crosslinking agent include a polyisocyanate compound, an epoxy compound, an aziridine compound, and a melamine crosslinking agent. The content of the external crosslinking agent in the adhesive is preferably 5 mass% or less based on 100 mass% of the base polymer. This is because when the proportion is within the above range, basic characteristics such as adhesive strength of the adhesive are easily exhibited appropriately.

The adhesive may be a radiation curable adhesive that increases the polymer crosslinking degree at a site irradiated with radiation such as ultraviolet rays to lower the adhesive force. Examples of the radiation curable adhesive include an addition-type radiation curable adhesive. The addition-type radiation curable adhesive contains: a base polymer such as an acrylic polymer; and a radiation-polymerizable monomer component or oligomer component having a functional group such as a radiation-polymerizable carbon-carbon double bond.

Examples of the radiation-polymerizable monomer component include urethane (meth)acrylate, trimethylolpropane tri(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, and 1,4-butanediol di(meth)acrylate. Examples of the radiation-polymerizable oligomer component include urethane-based, polyether-based, polyester-based, polycarbonate-based, and polybutadiene-based oligomers. The oligomer component preferably has a molecular weight of about 100 to 30000. The content of the monomer component and the oligomer component in the radiation curable adhesive may be appropriately determined as long as the adhesive force can be reduced. For example, the content of the monomer component and the oligomer component is preferably 40 to 150 mass% based on 100 mass% of the base polymer.

As the addition-type radiation curable adhesive, for example, an adhesive disclosed in JP S60-196956 A may be used.

Examples of the adhesive also include an immanent radiation curable adhesive. The immanent radiation curable adhesive contains a base polymer having a functional group such as a radiation-polymerizable carbon-carbon double bond in a polymer side chain, a polymer main chain, or a polymer main chain terminal. The immanent radiation curable adhesive easily suppresses a case where low molecular weight components move in the adhesive to cause unintentional temporal change in adhesive property.

The base polymer contained in the immanent radiation curable adhesive preferably has an acrylic polymer as the basic skeleton. As the acrylic polymer, the acrylic polymers described above can be applied. Examples of the method for introducing a radiation-polymerizable carbon-carbon double bond into an acrylic polymer include the following method. First, raw material monomers containing a monomer having a predetermined functional group (first functional group) are copolymerized to obtain an acrylic polymer. Thereafter, a compound having a predetermined functional group capable of reacting with and bonding to the first functional group (second functional group) and a radiation-polymerizable carbon-carbon double bond is subjected to a condensation reaction or an addition reaction with the acrylic polymer. The condensation reaction or addition reaction is performed such that the radiation polymerizability of the carbon-carbon double bond is maintained.

Examples of the combination of the first functional group and the second functional group include: a carboxy group and an epoxy group; an epoxy group and a carboxy group; a carboxy group and an aziridyl group; an aziridyl group and a carboxy group; a hydroxy group and an isocyanate group; and an isocyanate group and a hydroxy group. Among these combinations, a combination of a hydroxy group and an isocyanate group; and a combination of an isocyanate group and a hydroxy group are suitable from the viewpoint of easily tracing the reaction.

Here, it is technically difficult to prepare a polymer having a highly reactive isocyanate group. Therefore, from the viewpoint of easy preparation or availability, the case where the first functional group on the acrylic polymer side is a hydroxy group and the second functional group is an isocyanate group is a more suitable combination. Examples of the isocyanate compound having both a radiation-polymerizable carbon-carbon double bond and an isocyanate group as the second functional group include methacryloyl isocyanate, 2-methacryloyloxyethyl isocyanate, and m-isopropenyl-$\alpha,\alpha$-dimethylbenzyl isocyanate. As the acrylic polymer having the first functional group, a polymer containing a monomer unit derived from a hydroxy group-containing monomer is suitable; and a polymer containing a monomer unit derived from an ether-based compound such as 2-hydroxyethyl vinyl ether, 4-hydroxybutyl vinyl ether, or diethylene glycol monovinyl ether is suitable.

The radiation curable adhesive also preferably contains a photopolymerization initiator. Examples of the photopolymerization initiator include $\alpha$-ketol compounds, acetophenone compounds, benzoin ether compounds, ketal compounds, aromatic sulfonyl chloride compounds, photoactive oxime compounds, benzophenone compounds, thioxanthone compounds, camphorquinone, halogenated ketones, acyl phosphinoxide, and acyl phosphonate. Examples of the $\alpha$-ketol compound include 4-(2-hydroxyethoxy)phenyl(2-hydroxy-2-propyl)ketone, $\alpha$-hydroxy-$\alpha,\alpha'$-dimethylaceto-phenone, 2-methyl-2-hydroxypropiophenone, and 1-hydroxycyclohexyl phenyl ketone. Examples of the acetophenone compound include methoxyacetophenone, 2,2-dimethoxy-2-phenylacetophenone, 2,2-diethoxyacetophenone, and 2-methyl-1-[4-(methylthio)-phenyl]-2-morpholinopropane-1. Examples of the benzoin ether compound include benzoin ethyl ether, benzoin isopropyl ether, and anisoin methyl ether. Examples of the ketal compound include benzyl dimethyl ketal. Examples of the aromatic sulfonyl chloride compound include 2-naphthalenesulfonyl chloride. Examples of the photoactive oxime compound include 1-phenone-1,2-propanedione-2-(O-ethoxycarbonyl)oxime. Examples of the benzophenone compound include benzophenone, benzoylbenzoic acid, and 3,3'-dimethyl-4-methoxybenzophenone. Examples of the thioxanthone compound include thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone.

The content of the photopolymerization initiator in the radiation curable adhesive is preferably 0.05 to 20 mass% based on 100 mass% of the base polymer.

In addition to the components described above, the adhesive may optionally contain additives such as a crosslinking accelerator, a tackifier, an anti-aging agent, and a colorant. The colorant may be a compound that is colored by irradiation with radiation (for example, leuco dye).

The acrylic polymer described above can be obtained by polymerizing raw material monomers. Examples of the polymerization method include solution polymerization, emulsion polymerization, bulk polymerization, and suspension polymerization. In the adhesive, the low molecular weight components are preferably contained in a smaller amount, and the number average molecular weight of the acrylic polymer is preferably 100000 or more. Within the above range, the dicing tape attached with a sheet for sinter bonding easily has a suitable washing property when used in semiconductor manufacturing.

The viscosity of the adhesive 22 is preferably $5 \times 10^3$ to $1 \times 10^7$ Pa·s, and more preferably $1 \times 10^4$ to $1 \times 10^6$ Pa·s. When the viscosity is within the above range, it is easy to maintain adhesion between the sheet for sinter bonding 10 and the base material 21 in a semiconductor manufacturing process. The viscosity of the adhesive 22 can be measured by the same method as in the composition for sinter bonding.

The thickness of the adhesive 22 in the cross-sectional direction is preferably 5 μm or more, and more preferably 10 μm or more. The thickness is preferably 100 μm or less, and more preferably 80 μm or less. This is because when the thickness is within the above range, there is a tendency that adhesion between the sheet for sinter bonding 10 and the base material 21 is maintained in a semiconductor manufacturing process, and the adhesive easily decomposes and disappears after sintering. The thickness of the adhesive 22 can be measured by observing the cross section of the dicing tape at 23°C with an electron microscope.

<Base material>

The base material 21 functions as a support in the dicing tape 20.

Examples of the base material 21 include a plastic base material. As the plastic base material, a plastic film is preferably used. Examples of the plastic base material include polyolefin, polyester, polyurethane, polycarbonate, polyether ether ketone, polyimide, polyetherimide, polyamide, wholly aromatic polyamide, polyvinyl chloride, polyvinylidene chloride, polyphenyl sulfide, aramid, fluororesin, cellulose resin, and silicone resin. Examples of the polyolefin include low density polyethylene, linear low density polyethylene, medium density polyethylene, high density polyethylene, ultra-low density polyethylene, random copolymerized polypropylene, block copolymerized polypropylene, homopolypropylene, polybutene, polymethylpentene, ethylene-vinyl acetate copolymer, ionomer resin, ethylene-(meth)acrylic acid copolymer, ethylene-(meth)acrylic acid ester copolymer, ethylene-butene copolymer, and ethylene-hexene copolymer. Examples of the polyester include polyethylene terephthalate, polyethylene naphthalate, and polybutylene terephthalate.

The material for forming the base material 21 may be one kind or two or more kinds.

The base material 21 may be configured as a single layer or may have a multilayer structure.

When the base material 21 is a plastic film, the base material 21 may be an unstretched film, a uniaxially stretched film, or a biaxially stretched film.

The main surface of the base material 21 on the side of the adhesive 22 may be surface-treated in order to enhance adhesion with the adhesive 22. Examples of the surface treatment include: physical treatments such as corona discharge treatment, plasma treatment, sand mat treatment, ozone exposure treatment, flame exposure treatment, high-pressure electric shock exposure treatment, and ionizing radiation treatment; chemical treatments such as chromic acid treatment; and undercoating treatment.

The thickness of the base material 21 is preferably 40 μm or more, more preferably 50 μm or more, and particularly preferably 55 μm or more. Within the above range, the base material 21 easily secures strength as a support. The thickness of the base material 21 is preferably 200 μm or less, more preferably 180 μm or less, and particularly preferably 150 μm or less. Within the above range, the base material 21 has appropriate flexibility, and handleability such as tackiness is easily improved in semiconductor manufacturing.

The dicing tape attached with a sheet for sinter bonding can be produced, for example, as follows.

First, an adhesive 22 is provided on a base material 21 to prepare a dicing tape 20. For example, the base material 21 made of resin can be prepared by a calender film formation method, a casting method in an organic solvent, an inflation extrusion method in a sealed system, a T-die extrusion method, a coextrusion method, a dry lamination method, or the like.

In order to provide the adhesive 22, first, an adhesive composition for forming the adhesive 22 is prepared. The adhesive composition is applied onto the base material 21 or a predetermined separator (release liner) to form an adhesive composition layer. The adhesive composition layer is dried as necessary (thermally crosslinked as necessary). At this time, examples of the method for applying the adhesive composition include roll coating, screen coating, and gravure coating. The temperature for drying the adhesive composition layer may be, for example, 80 to 150°C. The drying time may be, for example, 0.5 to 5 minutes. When the adhesive 22 is formed on a separator, the adhesive 22 having the separator is bonded to the base material 21.

The sheet for sinter bonding 10 can be prepared, for example, by applying the above-described varnish for sinter bonding onto a separator. Specifically, the prepared varnish is applied onto a predetermined separator to form a coating film, and the coating film is dried to obtain a sheet for sinter bonding 10 prepared on the separator.

The sheet for sinter bonding 10 can be attached to a dicing tape by the following method.

For example, the sheet for sinter bonding 10 is pressure-bonded to the adhesive 22 side of the dicing tape 20. The temperature for bonding is preferably 30 to 50°C. The pressure (linear pressure) is preferably 0.1 to 20 kgf/cm. When the adhesive 22 is a radiation curable adhesive, the adhesive 22 may be irradiated with radiation such as ultraviolet rays from the base material 21 side. The irradiation amount is preferably 50 to 500 $mJ/cm^2$, and more preferably 100 to 300 $mJ/cm^2$. The region to be irradiated (irradiation region D) may be, for example, the adhesive 22 in the region excluding the peripheral edge where the sheet for sinter bonding is bonded (for example, the central portion of the sheet for sinter bonding).

The dicing tape attached with a sheet for sinter bonding may have a separator (for protection before use) on the sheet for sinter bonding 10 (main surface opposite to the adhesive 22). When the separator is provided, the sheet for sinter bonding 10 and the adhesive 22 can be protected from being exposed. The separator can be peeled off before use in semiconductor manufacturing or the like.

Examples of the separator include a polyethylene terephthalate (PET) film, a polyethylene film, a polypropylene film, various plastic films surface-coated with a release agent (for example, a fluorine release agent or a long-chain alkyl acrylate release agent), and paper.

<Example of method for manufacturing semiconductor device>

FIGS. 2A to 2D show a part of the steps of an example of the method for manufacturing a semiconductor device using the dicing tape attached with a sheet for sinter bonding.

First, as shown in FIG. 2A, a semiconductor wafer 30 is bonded to the sheet for sinter bonding 10 of the dicing tape attached with a sheet for sinter bonding. Specifically, the semiconductor wafer 30 is pressed against the sheet for sinter bonding 10 with a pressure-bonding roller or the like to bond the same to the sheet for sinter bonding 10. The semiconductor wafer 30 may have a plurality of semiconductor elements elaborated thereon; and on the main surface on the side where the semiconductor wafer 30 is bonded to the sheet for sinter bonding 10, a planar electrode may be formed as an external electrode. The thickness of the planar electrode is, for example, 10 to 1000 nm. As the planar electrode, for example, a planar electrode made of silver can be applied. The planar electrode may be laminated on a titanium thin film formed on the semiconductor wafer. The thickness of the titanium thin film is preferably 10 to 1000 nm. The planar electrode and the titanium thin film can be formed by, for example, a vapor deposition method.

On the main surface of the semiconductor wafer 30 opposite to the sheet for sinter bonding 10, other electrode pads or the like may be formed for each semiconductor element.

The temperature for bonding the semiconductor wafer 30 is preferably 50 to 90°C, and the load is preferably 0.01 to 10 MPa. When the adhesive 22 of the dicing tape is a radiation curable adhesive, instead of irradiation with radiation in manufacturing the dicing tape, the adhesive 22 may be irradiated with radiation from the base material 21 side after the semiconductor wafer 30 is bonded. The irradiation amount is preferably 50 to 500 $mJ/cm^2$, and more preferably 100 to 300 $mJ/cm^2$.

Next, as shown in FIG. 2B, the semiconductor wafer 30 is diced. Specifically, in a state where the semiconductor wafer 30 is bonded, the semiconductor wafer 30 is diced using a rotating blade such as a dicing device to be divided into semiconductor chip units (in the drawing, cut portions are schematically represented by thick lines). By dicing, semiconductor chips having the sheet for sinter bonding 10 in a chip size are formed.

After dicing, a cleaning step of cleaning the semiconductor chip side by using a cleaning liquid such as water is performed as necessary. Thereafter, the semiconductor chip with the sheet for sinter bonding is picked up from the dicing tape (pickup step). For example, the semiconductor chip to be picked up can be picked up by using the pin member of the pickup mechanism, and then sucking and holding the semiconductor chip with a suction jig.

As shown in FIG. 2C, the semiconductor chip picked up as described above is temporarily fixed to a support substrate 40 (temporary fixing step). Examples of the support substrate 40 include: an insulating circuit substrate with wiring such as copper wiring on its surface; and a lead frame. The place where the semiconductor chip is mounted on the support substrate 40 may be the base surface such as copper wiring or a lead frame, or may be the surface of a plating film formed on the base surface. Examples of the plating film include a gold (Au) plating film, a silver (Ag) plating film, a nickel (Ni) plating film, a palladium (Pd) plating film, and a platinum (Pt) plating film. The temperature condition of the temporary fixing is preferably 50 to 90°C, which is a temperature range including 70°C and the vicinity thereof. The load condition of the pressing for temporary fixing is preferably 0.01 to 5 MPa, and the bonding time is preferably 0.01 to 5 seconds.

Thereafter, heating is performed at a high temperature for sinter-bonding, and the semiconductor chip is bonded to the support substrate 40 (sinter-bonding step). Through high temperature heating, the binder between the support substrate 40 and the semiconductor chip is thermally decomposed and volatilized, and the electro-conductive metal of the sinterable particle is sintered. As a result, a sintered layer is formed between the support substrate 40 and each semiconductor chip, and the support substrate 40 and the semiconductor chip are electrically connected. The temperature condition of the sinter-bonding is preferably 200 to 400°C, which includes 300°C and the vicinity thereof, and more preferably 330 to 350°C. The pressure condition of the sinter-bonding is preferably 40 MPa or less, more preferably 20 MPa or less, and particularly preferably 15 MPa or less. The bonding time for sinter-bonding is preferably 0.3 to 300 minutes, and particularly preferably 0.5 to 240 minutes. The sinter-bonding step is preferably performed using a device capable of simultaneously performing heating and pressurizing. For example, a flip chip bonder and a parallel plate press are assumed. From the viewpoint of preventing oxidation of the metal, the sinter-bonding step is preferably performed under any of a nitrogen atmosphere, a reduced pressure, and a reducing gas atmosphere.

As shown in FIG. 2D, the electrode pad of the semiconductor chip is electrically connected to the terminal of the support substrate 40 through a bonding wire 41 as necessary (wire bonding step). In order to protect the semiconductor chip and the bonding wire of the support substrate 40, a sealing resin may be formed (sealing step).

As described above, a semiconductor device can be manufactured by using the dicing tape attached with a sheet for sinter bonding. However, the above is an example of the manufacturing method, and other manufacturing methods can be applied.

[Example 1]

The sinterable particle, a commercially available copper nanoparticle; a-1 (5.0 parts by mass); the binder, polypropylene carbonate PPC; b-1 (weight average molecular weight 1,200,000, product name QPAC40, manufactured by Empower Materials) (0.5 parts by mass); and the dispersing solvent, methyl ethyl ketone MEK; c-1 (2.0 parts by mass) were mixed at 2000 rpm for 120 seconds with a hybrid mixer (ARE-310, manufactured by THINKY CORPORATION), thereby preparing a varnish for sinter bonding.

The obtained varnish was applied onto a release-treated film (MRA50, manufactured by Mitsubishi Plastics, Inc.) and dried to form a sheet having a thickness of 40 μm, thereby obtaining the sheet for sinter bonding of Example 1. The drying temperature was 110°C, and the drying time was 3 minutes. The content ratio of the sinterable particle in the sheet for sinter bonding of Example 1 was 90.9 mass%.

[Examples 2 to 6 and Comparative Examples 1 to 5]

Each of the sheets for sinter bonding of Examples 2 to 6 and Comparative Examples 1 to 5 was obtained under the same conditions as in Example 1 except that the materials shown in Table 1 were used in the parts by mass shown in Table 3 in the preparation of the varnish for sinter bonding.

[Table 1]

| | | Materials |
|---|---|---|
| Sinterable particle | a-1 | Copper nanoparticle; average particle size 180 nm |
| | a-2 | Copper nanoparticle; average particle size 200 nm |
| | a-3 | Copper nanoparticle; average particle size 200 nm |
| | a-4 | Copper nanoparticle; average particle size 260 nm, particle size distribution 70 to 500 nm |
| Binder | b-1 | Polypropylene carbonate (PPC); (weight average molecular weight 160000, product name QPAC40, manufactured by Empower Materials) |
| | b-2 | Polyethylene carbonate (PEC); (weight average molecular weight 180000, product name QPAC25, manufactured by Empower Materials) |
| | b-3 | Isobornyl cyclohexanol (MTPH); (Terusolve MTPH, liquid at normal temperature, manufactured by Nippon Terpene Chemicals, Inc.) |
| Dispersing solvent | c-1 | Methyl ethyl ketone (MEK) |
| | c-2 | Dioxane |

[Evaluation]

For each of Examples and Comparative Examples, the Hansen solubility parameter was measured under the following conditions, and varnish appearance, sheet appearance, and sinterability were evaluated. The results are shown in Tables 2 and 3.

(Hansen solubility parameter)

The HSP distance means the distance of HSP between two substances, and for example, in the embodiment, means the distance between the HSP of the sinterable particle and the HSP of the organic binder or the dispersing solvent.

HSP is the Hansen solubility parameter ($\delta$), is defined by a three-dimensional parameter ($\delta D$, $\delta P$, $\delta H$), and is represented by the formula (X): $\delta^2 = (\delta D)^2 + (\delta P)^2 + (\delta H)^2 \cdots$ (X) [In the formula (X), $\delta D$ represents a London dispersion force term, $\delta P$ represents a molecular polarization term (dipole-dipole force term), and 6H represents a hydrogen bond term.].

The Hansen solubility parameter was measured in terms of the Hansen sphere method for each of the copper nanoparticles a-1 to a-4, PPC b-1, and PEC b-2. The Hansen solubility parameter was measured in terms of the Smiles based on the information in databases for each of MTPH b-3, MEK c-1, and dioxane c-2, whose chemical structures have been known.

In the Hansen sphere method (Hansen dissolution sphere method), the Hansen solubility parameter was measured as follows.

The target sample was mixed with a solvent whose solubility parameter had been known to determine whether the sample was dissolved or dispersed, or not.

As the solvent, water, formic acid, acetic acid, methanol, ethanol, 1-propanol, 2-butanol, 1-pentanol, acetone, methyl ethyl ketone, tetrahydrofuran, N-methylpyrrolidone, N-methylformamide, N,N-dimethylformamide, ethyl acetate, cyclohexanone, xylene, toluene, hexane, and 1,4-dioxane were used.

The results of the solubility test were plotted in the three-dimensional space of the solubility parameter by using HSPiP (Hansen Solubility Parameters in Practice) Ver.5, and the HSP value was obtained.

For each of MTPH b-3, MEK c-1, and dioxane c-2, whose chemical structures had been known, Smiles was created, and the HSP value was calculated through calculation using HSPiP (Hansen Solubility Parameters in Practice) Ver.5.

Assuming that the Hansen solubility parameters of two substances A and B, 6A and $\delta B$, were $\delta A = (\delta DA, \delta PA, \delta HA)$ and $\delta B = (\delta DB, \delta PB, \delta HB)$, the distance between the HSP values can be calculated by the formula $[4 \times (\delta DA - \delta DB)^2 + (\delta PA - \delta PB)^2 + (\delta HA - 6HB)^2]^{0.5}$.

For each of the materials measured above, the dispersion term, polarity term, and hydrogen bond term of the Hansen solubility parameter are shown in Table 2 below.

[Table 2]

|  |  | HSP | | |
| --- | --- | --- | --- | --- |
|  |  | $\delta D$ | $\delta P$ | $\delta H$ |
| Sinterable particle | a-1 | 18.2 | 11.7 | 14.5 |
|  | a-2 | 21.4 | 5.6 | 24.5 |
|  | a-3 | 23.0 | 9.2 | 16.2 |
|  | a-4 | 15.4 | 10.3 | 4.0 |
| Binder | b-1 | 18.1 | 13.2 | 5.3 |
|  | b-2 | 21.6 | 8.4 | 14.0 |
|  | b-3 | 17.4 | 2.8 | 4.5 |
| Dispersing solvent | c-1 | 15.9 | 8.0 | 5.1 |
|  | c-2 | 17.5 | 7.2 | 7.8 |

(Varnish appearance)

In the preparation of the varnish, the varnish appearance after mixing with a hybrid mixer was observed and evaluated according to the following criteria.

○: Color unevenness or sedimentation of sinterable particles was not observed in the varnish.

×: Color unevenness, sedimentation of sinterable particles, or separation of the sinterable particle from the binder was observed in the varnish.

(Sheet appearance)

The appearance of the sheet for sinter bonding was observed and evaluated according to the following criteria.

○: No particle unevenness (color unevenness) was observed in the sheet.

△: Particle unevenness was observed in the sheet, but cracking or chipping did not occur during sheet processing.

×: Cracking or chipping occurred during sheet processing, or the obtained sheet was brittle and could not maintain its shape.

(Sinterability)

Using the sheets for sinter bonding of Examples and Comparative Examples, sinter-bonding was performed as follows, and the appearance after sintering was observed.

First, a silicon chip (5 mm square, thickness 350 $\mu$m) having a planar electrode (5 mm square) on one surface thereof was prepared. As the planar electrode, one having a Ti layer (thickness 100 nm) and Ag layer (thickness 750 nm) on the silicon chip was used.

Next, the sheet for sinter bonding was bonded to the planar electrode on the silicon chip using a laminator having a pressure-bonding roller. The bonding temperature was 70°C, the load (pressure by the pressure-bonding roller) was 0.3 MPa, and the speed of the pressure-bonding roller was 10 mm/sec. As described above, a silicon chip having the sheet for sinter bonding of 5 mm square was obtained.

The silicon chip attached with the sheet for sinter bonding was sinter-bonded to a copper plate (thickness 3 mm) entirely covered with an Ag film (thickness 5 $\mu$m). Specifically, sintering was performed using a sintering device (HTM-3000, manufactured by Hakuto Co., Ltd.) such that the sheet for sinter bonding was positioned between the copper plate and the silicon chip. During sintering, the pressure applied in the thickness direction was 20 MPa, the heating temperature was 275°C, and the heating time was 5 minutes.

Note that a sheet for sinter bonding having a sheet shape could not be prepared in the formulation of Comparative Example 5, and therefore, the sinterability test could not be performed therefor.

The appearance of the silicon chip sintered under the above conditions was observed and evaluated according to the following criteria.

○: In a front view of the sintered silicon chip, the sheet for sinter bonding was not observed (the shape thereof was maintained without protruding from the silicon chip).

×: In a front view of the sintered silicon chip, the component of the sheet for sinter bonding leaking to the outer periphery of the silicon chip was observed, but the silicon chip and the copper plate were bonded to each other.

××: In a front view of the sintered silicon chip, the component of the sheet for sinter bonding remarkably leaked to the outer periphery of the silicon chip, and the silicon chip and the copper plate were not bonded to each other.

[Table 3]

| | | | Example | | | | | | Comparative Example | | | | |
|---|---|---|---|---|---|---|---|---|---|---|---|---|---|
| | | | 1 | 2 | 3 | 4 | 5 | 6 | 1 | 2 | 3 | 4 | 5 |
| Formulation | Sinterable particle | a-1 | 5.0 | 5.0 | 5.0 | | | | | | | | |
| | | a-2 | | | | 5.0 | | | 5.0 | 5.0 | | | |
| | | a-3 | | | | | 5.0 | | | | 5.0 | 5.0 | |
| | | a-4 | | | | | | 5.0 | | | | | 5.0 |
| | Binder | b-1 | 0.5 | 0.3 | | | | 0.5 | 0.5 | 0.3 | 0.5 | 0.3 | |
| | | b-2 | | | 0.5 | 0.5 | 0.5 | | | | | | 0.5 |
| | | b-3 | | 0.2 | | | | | | 0.2 | | 0.2 | |
| | Dispersing solvent | c-1 | 2.0 | 2.0 | | | | 2.0 | 2.0 | 2.0 | 2.0 | 2.0 | |
| | | c-2 | | | 2.0 | 2.0 | 2.0 | | | | | | 2.0 |
| Evaluation | | HSP Db | a-1, b-1 | a-1, b-1 / a-1, b-3 | a-1, b-2 | a-2, b-2 | a-3, b-2 | a-4, b-1 | a-2, b-1 | a-2, b-1 / a-2, b-3 | a-3, b-1 | a-3, b-1 / a-3, b-3 | a-4, b-2 |
| | | | 9 | 9 / 14 | 8 | 9 | 4 | 6 | 22 | 22 / 22 | 15 | 15 / 18 | 16 |
| | | HSP Ds | a-1, c-1 | a-1, c-1 | a-1, c-2 | a-2, c-2 | a-3, c-2 | a-4 ,c-1 | a-2, c-1 | a-1, c-1 | a-3, c-1 | a-3, c-1 | a-4, c-2 |
| | | | 11 | 11 | 8 | 11 | 14 | 3 | 22 | 22 | 17 | 17 | 6 |
| | | Varnish appearance | ○ | ○ | ○ | ○ | ○ | ○ | × | × | ○ | ○ | × |
| | | Sheet appearance | ○ | Δ | ○ | ○ | ○ | ○ | Δ | Δ | Δ | Δ | × |
| | | Sinterability | ○ | ○ | ○ | ○ | ○ | ○ | ×× | × | ×× | × | - |
| | | Determination | ○ | Δ | ○ | ○ | ○ | ○ | × | × | ×× | × | ×× |

In the above table,

Db represents the distance between the Hansen solubility parameter of the sinterable particle and the Hansen solubility parameter of the binder.

Ds represents the distance between the Hansen solubility parameter of the sinterable particle and the Hansen solubility parameter of the dispersing solvent.

From the above results, in the varnishes for sinter bonding of Examples 1 to 6, color unevenness and sedimentation of sinterable particles were not observed. In addition, in the sheets for sinter bonding of Examples 1 to 6, cracking or chipping did not occur during sheet processing; and in plan view of the sintered silicon chip, the shape of the sheet was maintained without protruding from the silicon chip.

**Claims**

1. A sheet for sinter bonding comprising: a sinterable particle containing an electro-conductive metal; and a binder, wherein a distance Db between a Hansen solubility parameter of the sinterable particle and a Hansen solubility parameter of the binder is less than 15.0.

2. The sheet for sinter bonding according to claim 1, containing no binder other than a thermally decomposable polymer binder the distance Db of which is less than 15.0.

3. The sheet for sinter bonding according to claim 1 or 2, wherein the distance Db is 10.0 or less.

4. The sheet for sinter bonding according to claim 1 or 2, wherein the binder contains at least one selected from the group consisting of polypropylene carbonate and polyethylene carbonate.

5. A dicing tape attached with a sheet for sinter bonding, comprising:

   a dicing tape having a base material and an adhesive; and
   the sheet for sinter bonding according to claim 1 or 2 attached to the adhesive of the dicing tape.

6. A composition for sinter bonding comprising: a sinterable particle containing an electro-conductive metal; and a binder,
   wherein a distance Db between a Hansen solubility parameter of the sinterable particle and a Hansen solubility parameter of the binder is less than 15.0.

7. A varnish for sinter bonding comprising: a sinterable particle containing an electro-conductive metal; a binder; and a dispersing solvent,

   wherein a distance Db between a Hansen solubility parameter of the sinterable particle and a Hansen solubility parameter of the binder is less than 15.0, and
   a distance Ds between a Hansen solubility parameter of the sinterable particle and a Hansen solubility parameter of the dispersing solvent is less than 15.0.

FIG. 1

FIG. 2A

FIG. 2B

FIG. 2C

FIG. 2D

**EP 4 745 967 A2**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2024010136 A
- WO 2008065728 A1
- JP 60196956 A